(19) Europäisches Patentamt
European Patent Office
Office européen des brevets

(11) **EP 3 633 527 A1**

(12) **EUROPÄISCHE PATENTANMELDUNG**

(43) Veröffentlichungstag:
08.04.2020 Patentblatt 2020/15

(51) Int Cl.:
*G06F 17/50* (2006.01)

(21) Anmeldenummer: 18198916.1

(22) Anmeldetag: 05.10.2018

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Dr. Binde Ingenieure, Design & Engineering GmbH**
**65207 Wiesbaden (DE)**

(72) Erfinder:
• **Kretzschmar, Fritz**
**64283 Darmstadt (DE)**
• **Korolonek, Christian**
**65193 Wiesbaden (DE)**

(74) Vertreter: **2K Patentanwälte Blasberg Kewitz & Reichel**
**Partnerschaft mbB**
**Schumannstrasse 27**
**60325 Frankfurt am Main (DE)**

(54) **VERFAHREN UND VORRICHTUNG ZUM BESTIMMEN PHYSIKALISCHER BESTIMMUNGSFREMDER STROMPFADE IN EINER ELEKTRISCHEN BAUEINHEIT MIT HILFE MODELLIERTER GELADENER TEILCHEN**

(57) Die vorliegende Erfindung umfasst ein Verfahren zum Bestimmen eines oder mehrerer physikalischer Strompfade zwischen mindestens zwei Bauteilen, die mit elektrischen Potentialen beaufschlagt sind, mittels mindestens eines elektrisch geladenen Teilchens, wobei das Verfahren die Schritte des Verwendens eines digitalen Modells der Bauteile, deren elektromagnetische Materialeigenschaften in dem digitalen Modell gesetzt sind, wobei in dem digitalen Modell ein Luftvolumen vorliegt, welches die Bauteile umgibt, und des Erzeugens räumlicher Gitter auf der Basis des digitalen Modells; und den Schritt des Beaufschlagens mindestens zweier der digital modellierten Bauteile mit unterschiedlichen elektrischen Potentialen, wobei mindestens eins der digital modellierten Bauteile als Quelle bestimmt wird und mindestens ein weiteres als Ziel bestimmt wird; und den Schritt des Positionierens des mindestens einen modellierten elektrisch geladenen Teilchens, auf mindestens einem der mit elektrischen Potentialen beaufschlagten digital modellierten Bauteile; und den Schritt des Bestimmens eines elektromagnetischen und insbesondere eines elektrischen Feldes, aus den vorherigen Schritten und, mittels eines numerischen elektromagnetischen Bestimmungsverfahrens; und den Schritt des Bestimmens einer oder mehrerer Teilchenbahn / en bzw. partiellen Teilchenbahnen, mittels eines Verfahrens zur Berechnung der Propagation geladener Teilchen, wobei die Berechnungen der Teilchenbahnen auf der Basis der Berechnung des elektrischen Feldes aus den vorherigen Schritten erfolgt; und den Schritt des Bestimmens eines oder mehrerer zurückgelegten / r Gesamtpfade /s des mindestens einen modellierten Teilchens und der Bestimmung von resultierenden physikalischen Strompfaden, zwischen der oder den Quelle/n und dem oder den Zielen, wobei an einer oder verschiedenen Stellen der Quelle /n modellierte elektrisch geladene Teilchen positioniert werden können, und wobei verschiedene Verfahren zur Berechnung der elektromagnetische Felder verwendet werden können und verschiedene zusätzliche Bauteile mit unterschiedlichen Materialien, insbesondere jedoch Leiter und Isolatoren mit in die Berechnung einbezogen werden können, und entsprechend der physikalischen Analoga, d.h. den realen Bauteilen, verwendet werden.

Weiterhin wird eine Vorrichtung offenbart, die das Verfahren bzw. Programm ausführt.

EP 3 633 527 A1

## Beschreibung

Die Erfindung betrifft ein Verfahren und eine Vorrichtung zum Bestimmen physikalischer Strompfade, und insbesondere ein Verfahren und eine Vorrichtung zur Bestimmung bestimmungsfremder physikalischer Strompfade zwischen mindestens zwei Bauteilen, die mit unterschiedlichen Potentialen beaufschlagt sind, anhand bestimmter Pfade elektrisch geladener modellierter Teilchen.

## Gebiet der Erfindung

Ein essentielles Erfordernis im Bereich der Produktion von Hochvolt-, Mittelvolt- und Niedervoltvorrichtungen liegt in der Vermeidung von Spannungsdurchschlägen, zwischen mit Potentialen beaufschlagten Bauteilen, z.B. durch/über Leiterplatinen und/oder Dielektrika. Das beschriebene Erfordernis ist zum einen für die Betriebssicherheit, z.B. zur Vermeidung von Bränden, und zum anderen zur Lebensdauererhöhung, im Sinne des "Product Lifecycle Management", PLM, von großem Interesse.

Um dieses Erfordernis befriedigen zu können, werden in der Regel entweder bestimmte Schirmungsmaterialien, wie z.B. Nu-Metalle, an entsprechenden Stellen eingesetzt und verwendet, oder die jeweiligen Bauteile werden in größeren Abständen zueinander platziert.

Jedoch bringen Schirmungsmaterialien automatisch ein höheres Gewicht und größere Kosten mit sich, da diese Materialien im Normalfall teuer sind, und einen größeren Fertigungsaufwand mit sich tragen. Auf der anderen Seite machen größere Beabstandungen das Gesamtbauteil unumgänglich größer.

Um die zuvor genannten Probleme zu minimieren, werden in der Industrie seit langem manuelle Distanzoptimierungsverfahren verwendet, mit denen die Beabstandungen gemessen und optimiert werden können. Für komplizierte Bauteile ist dieser Prozess jedoch aufwändig und mit enormen Kosten verbunden. Des Weiteren besteht keine Erfolgsgarantie, sodass häufige Prototypentests nötig sein können, die unter Umständen destruktiv sind, d.h. den Prototypen zerstören, was weitere Kosten mit sich zieht.

Eine bequeme Lösung für das genannte Problem wäre der Einsatz eines numerischen Bestimmungsverfahren, mit dem die Distanzen im Vorfeld einer Produktion bestimmt und optimiert werden können. Hierzu kommen insbesondere numerische Bestimmungsverfahren in Frage.

Seit mehreren Jahrzehnten gewinnen numerische Berechnungen/ bzw. Vorberechnungen zunehmend an Einfluss in allen Sparten der modernen Industrie. Hierbei werden insbesondere Verfahren, welche unter dem Namen "Computer Aided Design", CAD, zusammengefasst werden, benutzt; und finden insbesondere in der Strukturberechnung, in der Fluidberechnung und in diversen Optimierungsfeldern Anwendung. Im Vergleich zu diesen Anwendungsfeldern der numerischen Berechnung, werden im Bereich der elektromagnetischen Simulation, in die auch die Berechnung der genannten Strompfade fällt, noch relativ wenige Simulationen durchgeführt.

Dennoch gibt es einige Softwareprogrammpakete, mit denen auch elektromagnetische Berechnungen im Zusammenhang mit elektrisch geladenen Teilchen durchgeführt werden können. Hierzu zählen insbesondere ANSYS-MAXWELL, CST-MICROWAVE, OPERA sowie MAGNETICS for SC/NX.

Die Europäische Patentanmeldung EP 2 953 042 A1 stellt eine Vorrichtung und ein Verfahren zum Ermitteln eines kürzesten Strompfades zwischen wenigstens zwei, in einem bestimmungsgemäßen Betrieb mit einem unterschiedlichen elektrischen Potential beaufschlagten elektrisch leitfähigen Bauteilen einer eine Mehrzahl von elektrisch leitfähigen und elektrisch isolierten Bauteilen aufweisende Baueinheit, vor. Mit der genannten Erfindung kann die geometrisch kürzeste Leitungsstrecke, auf der Basis einer weitestgehend geometrischen Methode, bestimmt werden. Jedoch werden in der Betrachtung jegliche physikalischen Effekte vernachlässigt. In der Realität bilden sich Strompfade, wie z.B. Lichtbögen, nicht über einen kürzesten Weg aus, sondern über den Weg mit der geringsten Wirkung. Im Falle eines Stromes also entlang einer elektrischen Feldlinie, die eine extreme Wirkung, im Sinne des Lagrangeschen Prinzips, aufweist.

## Überblick über die Erfindung

Das zu lösende Problem aus dem Stand der Technik ist die Bestimmung von physikalischen Strompfaden zwischen mindestens zwei, mit unterschiedlichen Potentialen beaufschlagten Bauteilen.

Vorteilhafterweise verlaufen die physikalischen Strompfade genau entlang den elektrischen Feldlinien, auf denen ein oder mehrere geladene Teilchen am schnellsten von einem, mit einem höheren Potential beaufschlagten Bauteil, zu einem anderen, mit einem geringeren Potential beaufschlagten Bauteil, bewegen, sodass der / die hierdurch bestimmte / n Strompfad / e eine minimale Wirkung, im Sinne des Prinzips von Lagrange, besitzt / en und somit physikalisch ist / sind.

Gelöst wird das Problem durch ein erfindungsgemäßes Verfahren nach einem Hauptanspruch der vorliegenden Erfindung; sowie weiteren vorteilhaften Ausführungen der Unteransprüche. Ein erster Hauptanspruch offenbart Verfahren zum Bestimmen eines oder mehrerer physikalischer Strompfade zwischen mindestens zwei Bauteilen, die mit elektrischen Potentialen beaufschlagt sind, mittels mindestens eines elektrisch geladenen Teilchens, wobei das Verfahren die Schritte, des Verwendens eines digitalen Modells der Bauteile, deren elektromagnetische Materialeigenschaften in dem digitalen Modell gesetzt sind, wobei in dem digitalen Modell ein Luftvolumen vorliegt, welches die Bauteile umgibt. Es erfolgt ein Erzeugen räumlicher Gitter auf der Basis des digitalen Modells. Danach erfolgt ein Beaufschlagen mindestens zweier der digital modellierten Bauteile mit unterschiedlichen elektrischen Potentialen, wobei mindestens eins der digital modellierten Bauteile als Quelle bestimmt wird und mindestens ein weiteres als Ziel bestimmt wird. Es erfolgt das Positionierens des mindestens einen modellierten elektrisch geladenen Teilchens auf mindestens einem der mit elektrischen Potentialen beaufschlagten digital modellierten Bauteile; dann folgt ein Bestimmen elektromagnetischer Felder und insbesondere eines elektrischen Feldes, aus vorherigen Schritten, mittels eines numerischen elektromagnetischen Bestimmungsverfahrens; des Bestimmens einer oder mehrerer Teilchenbahn / en bzw. partiellen Teilchenbahnen, mittels eines Verfahrens zur Berechnung der Propagation geladener Teilchen, wobei die Berechnungen der Teilchenbahnen auf der Basis der Berechnung des elektrischen Feldes aus vorherigen Schritten erfolgt; und des Bestimmens eines oder mehrerer zurückgelegten / r Gesamtpfade /s des mindestens einen modellierten Teilchens und Bestimmung von resultierenden physikalischen Strompfaden, zwischen der oder den Quelle/n und dem oder den Zielen.

Das beschriebene digitale Modell der Bauteile, dessen Verwendung als Basis der Erfindung dient, kann beispielsweise ein digitales Modell sein, das neu erstellt wird, oder aus einem oder mehreren Modellen oder Teilmodellen, oder einer Kombination hieraus besteht.

Im Falle einer neuen Erzeugung eines digitalen Modells oder einer Modifikation, kommen handelsübliche Programme in Frage, insbesondere "Computer Aided Design", CAD, Programme. Insbesondere kommen die Programme DESIGNMODELER der Firma ANSYS, sowie andere Design Programme der Firma ANSYS; CATIA der Firma Dassault, sowie andere Design Programme der Firma Dassault, insbesondere SOLIDWORKS; und die Programme NX und "Simcenter", SC, der Firma Siemens, sowie andere Design Programme der Firma Siemens, in Frage. Bevorzugt kommt jedoch das Programm NX / SC der Firma Siemens in Frage.

Neu Erstellen eines digitalen Modells kann hierbei heißen, dass ein reales Modell oder ein hypothetisches Testmodel, durch einen Experten auf dem Gebiet des Designs oder der Konstruktion erstellt wird; oder dass durch technische Hilfsmittel, wie beispielsweise Laser- oder Kameravermessungen, auch reale Bauteile automatisiert oder halbautomatisiert in ein digitales Modell überführt werden.

Außerdem sind auch Modifikationen und Zusammenführungen von bestehenden digitalen Modellen möglich. Insbesondere kann es der Fall sein, dass bereits ein digitales Modell der Bauteile besteht und dass dieses um ein digitales Luftvolumen erweitert wird.

In einer bevorzugten Ausführungsform liegt das umgebende Propagationsvolumen, wie oben erwähnt als Luftvolumen vor. In weiteren Ausführungsformen sind jedoch auch Teilchenpropagationsvolumina denkbar, die mit anderen passenden dielektrischen Materialien beaufschlagt sind. In der weiteren Beschreibung wird jedoch der Begriff Luftvolumen verwendet, wobei dieser synonym mit dem Begriff des Teilchenpropagationsvolumens zu verstehen ist.

In einer bevorzugten Ausführungsform wird auf der Basis des digitalen Modells ein räumliches Gitter bzw. eine räumliche digitale Vermaschung erstellt, sodass digitale räumliche Gittermodelle der Bauteile vorliegen.

In weiteren Ausführungsformen ist es weiterhin auch möglich, dass bereits digitale räumliche Gitter der Bauteile oder mancher Bauteile vorliegen und direkt verwendet werden können oder modifiziert werden können.

Für die Erstellung der digitalen räumlichen Gitter können verschiedene Gittererstellungsverfahren verwendet werden, um drei-dimensionale Gitter, mit verschiedenen Elementen zu erstellen, wie beispielsweise tetrahedralen, hexahedralen, pyramidalen, prismenförmigen, oder allgemein polygonalen Elementen oder einer Kombination hieraus; oder zwei-dimensionale Gitter, mit verschiedenen Elementen, wie beispielsweise triangularen, rechteckigen, oder allgemeinen Oberflächen oder einer Kombination hieraus oder ein-dimensionale Gitter, mit verschiedenen Elementen, wie beispielsweise linearen oder allgemein kurvenförmigen; oder null-dimensionale Gitter mit Punktelementen, verwendet werden, oder einer Kombination aus der aufgezählten.

Insbesondere können Gittererstellungsteilprogramme, handelsüblicher Programme, insbesondere der Firmen ANSYS, Dassault oder Siemens verwendet werden oder andere Gittererstellungs- oder Vermaschungsprogramme; wobei auch direkt Gitter ohne die Verwendung eines Gittererstellungsprogrammes eingegeben werden können.

Die erstellten Gitter können dabei in verschiedenen Formaten vorliegen oder erstellt werden; und des Weiteren in andere Formate überführt werden.

Im Prozess der digitalen Modellerstellung oder in der Gittererzeugung, ist auf das Vorhandensein eines, die digitalisierten Bauteile umgebenden Gitters zu achten, welches im Folgenden mit elektromagnetischen Eigenschaften beaufschlagt wird, die der Luft (bzw. eines anderen passenden Dielektrikums) entsprechen, und als Luftgitter bezeichnet wird.

Außerdem werden allen weiteren digitalisierten Bauteilen bzw. deren zugehörigen Gittern elektromagnetische Materialeigenschaften zugewiesen. Insbesondere können hierbei elektromagnetische Materialeigenschaften zugewiesen werden, die zu Materialien korrespondieren, die aus der Familie der elektrischen Isolatoren, wie beispielsweise Glas, stammen; oder es können elektromagnetische Materialeigenschaften zugewiesen werden, die zu Materialien korrespondieren, die aus der Familie der elektrischen Leiter, wie beispielsweise Kupfer oder Graphit, stammen. Durch die zugewiesenen elektromagnetischen Materialien werden alle digitalen Bauteile klar als Leiter oder nicht-Leiter identifiziert.

Von den Bauteilen bzw. den digitalisierten Modellen der Bauteile bzw. den räumlichen Gittern, die zu den digitalisierten Modellen der Bauteile korrespondieren, wird mindestens eins als Quelle identifiziert und ein weiteres als Ziel, wobei auch eine Mehrzahl von Quellen und / oder eine Mehrzahl von Zielen vorliegen können.

Folgend wird mindestens eine Quelle und ein Ziel mit jeweils einem elektrischen Potential beaufschlagt, wobei das Potential der Quelle größer ist als das des Ziels, sodass sich in dem zu dem digitalen Modell korrespondierenden realen Modell elektrische Felder von der Quelle zum Ziel ausbreiten können.

Es sei angemerkt, dass in besonders bevorzugten Ausführungsformen auch eine Mehrzahl von Quellen und / oder Zielen vorliegen kann.

Weiterhin wird an einer Stelle von mindestens einer Quelle mindestens ein digital modelliertes elektrisch geladenes Teilchen platziert. In der Realität korrespondierte dieses Teilchen zu einem physikalischen Punktteilchen, wie beispielsweise einem Elektron, Positron oder Ion (ohne Ausdehnung). In dem Verfahren zur Berechnung wird ein korrespondierendes digital modelliertes, elektrisch geladenes, punktförmiges Teilchen oder eine Mehrzahl hiervon verwendet, wobei dieses modellierte elektrisch geladene Teilchen folglich keine Ausdehnung aufweist. Es ist jedoch an dieser Stelle angemerkt, dass auch ausgedehnte modellierte elektrisch geladene Teilchen verwendet werden könnten.

Den Teilchen wird hierbei zumindest eine Masse und eine Ladung zugwiesen, wobei in der vorliegenden Erfindung die Massen und Ladungen aller modellierten Teilchen vorzugsweise gleich zu wählen sind.

In besonders bevorzugten Ausführungsformen wird eine Vielzahl von modellierten elektrisch geladenen Teilchen auf den Oberflächen, den Außenkanten und den Außenpunkten einer oder aller Quellen platziert. Insbesondere ist eine äquidistante Platzierung bevorzugt, sodass eine Vielzahl von modellierten elektrisch geladenen Teilchen gleichmäßig auf der oder den Quelle / n platziert ist / sind.

Hierbei kann es von Interesse sein, Durchschlagstrompfade, von einer Quelle zu einem oder mehreren Zielen zu bestimmen; wobei in diesem Fall eine Quelle bestimmt wird und mit einem oder mehreren modellierten elektrisch geladenen Teilchen beaufschlagt wird.

Weiterhin können auch Durchschlagstrompfade von mehreren Quelle zu einem oder mehreren Zielen zu bestimmen sein; wobei in diesem Fall mehrere Quelle bestimmt werden und mit einem oder mehreren modellierten elektrisch geladenen Teilchen beaufschlagt werden, und wobei in diesem Falle die Startidentifizierungen der Teilchen bestimmt werden, um für jedes Teilchen festzuhalten, d.h. zu speichern, von welcher Quelle gestartet wird.

In der folgenden Beschreibung werden insbesondere Schritte des Verfahrens beschrieben, in denen Berechnungen beschrieben werden. Hierbei werden die Begriffe der digital modellierten Bauteile und deren korrespondierenden realen Bauteilen synonym verwendet; weiterhin gilt gleiches für die modellierten elektrisch geladenen Teilchen und deren korrespondierende reale Teilchen.

Weiterhin wird in einem Berechnungsschritt mindestens ein elektrisches Feld bestimmt, wobei auch weitere Felder, insbesondere eine magnetische Flussdichte, ein dielektrisches Feld oder ein magnetisches Feld, sowie entsprechende Vektorpotential- und / oder Skalarpotentialfelder bestimmt werden können.

Falls mehrere Felder bestimmt werden, so können auch deren Interaktionen miteinander bestimmt werden.

In einer besonders bevorzugten Ausführungsform wird ein Finite Elemente, FE, Verfahren auf der Basis des verwendeten Gitters und der elektromagnetischen Materialien verwendet, um die Felder zu bestimmen, beispielsweise mit dem Programm MAGNETICS for NX der Firma Dr. Binde Ingenieure, Design & Engineering GmbH, wobei auch andere elektromagnetischen Bestimmungsverfahren möglich sind, insbesondere der Firma ANSYS, Siemens und / oder Dassault.

Im Rahmen der elektromagnetischen Feldberechnung sind auch Verfeinerungen und Vergröberungen des verwendeten Gitters möglich, insbesondere adaptive Verfeinerungen.

In einer besonders bevorzugten Ausführungsform ist das bestimmte elektrische Feld, mit dem die geladenen Teilchen beschleunigt werden, ein statisches elektrisches Feld und kann aus dem Gaussschen Gesetz bestimmt werden.

Weiterhin sind auch andere Bestimmungsverfahren für die elektromagnetischen Felder denkbar, insbesondere jedoch Verfahren aus der Klasse der Finiten Differenzen, FD.

In einer weiteren Ausführungsform kann das bestimmte elektrische Feld auch ein zeitabhängiges elektrisches Feld sein, wobei in diesem Fall ein iteratives Zeitschrittverfahren verwendet wird, in dem zunächst die elektrischen Felder oder die elektromagnetischen Felder bestimmt werden. In diesem Fall ist eine Vielzahl von Kombinationen möglich, wobei elektromagnetische Felder insbesondere nach einer Elektrodynamischen bzw. Elektroquasistatischen Lösung, einer Magnetodynamischen bzw. Magnetoquasistatischen Lösung oder einer Wellen-Lösung bestimmt werden können.

Weiterhin wird in einem weiteren Berechnungsschritt die Propagation / en des / der modellierten elektrisch geladenen Teilchen bestimmt, wobei hierbei ein Verfahren zur Berechnung elektrisch geladener Teilchen verwendet wird.

In einer besonders bevorzugten Ausführungsform ist das Verfahren zur Berechnung der Teilchenbahnen ein Particle In Cell, PIC, Verfahren. In einem PIC Verfahren werden die Teilchenbahnen elektrisch geladener Teilchen in einem elektromagnetischen Feld bestimmt. In der Vorliegenden Erfindung wird mindestens das elektrische Feld zur Berechnung der Teilchenbahnen verwendet. Hierzu wird das elektrische Feld an den jeweiligen Teilchenpositionen durch ein Verfahren zum Ermitteln oder Interpolieren von Feldwerten an den einzelnen Teilchenpositionen verwendet, sodass für die modellierten elektrisch geladenen Teilchen jeweilige Geschwindigkeiten und Positionen auf der Basis einer resultierenden Kraft bestimmt werden können.

Hierbei kann die resultierende Kraft insbesondere die Lorentz- oder die Coulombkraft sein, wobei im Falle der Lorentzkraft auch Informationen über die magnetische Flussdichte übergeben werden.

In dem Verfahren zur Berechnung von Teilchenbahnen werden zeitliche Iterationsschritte verwendet, wobei diese gleich mit den Zeitschritten des Verfahrens zur Berechnung der elektrischen Felder sein können, oder nicht.

Bevorzugt sind die zeitlichen Iterationsschritte des Verfahrens zur Berechnung von Teilchenbahnen gleich mit denen des Verfahrens zur Berechnung der elektrischen Felder; und besonders bevorzugt weist nur das Verfahrens zur Berechnung von Teilchenbahnen zeitlichen Iterationsschritte auf, sodass das elektromagnetische Feld lediglich einmal an das Verfahren zur Berechnung von Teilchenbahnen übermittelt wird.

Im Falle zeitlich veränderlicher Felder können die Berechnungsschritte für die Felder und Teilchen iterativ aufeinanderfolgend ausgeführt werden, wobei zunächst ein elektrisches Feld bestimmt wird und anschließend die Propagation / en des / der Teilchen.

Die Positionen der Teilchen zu einem neuen Zeitschritt werden mit Hilfe der alten Positionen, in Kombinationen mit Geschwindigkeiten der modellierten elektrisch geladenen Teilchen bestimmt, wobei dieser Schritt auch "Steppen" (vom Englischen to step, bewegen, anstoßen) genannt wird.

Die Geschwindigkeiten der Teilchen können durch verschiedene Verfahren bestimmt werden, wobei hierbei auch Zwischenschritte verwendet werden können. Insbesondere kann ein Boris, ein Boris-Buenemann oder ein Verfahren aus der Klasse der Verlet Verfahren verwendet werden. Dabei werden die Geschwindigkeiten der Teilchen zu jedem neuen Zeitschritt auf der Basis der bestimmten elektrischen oder elektromagnetischen Felder bestimmt.

Zu jedem Zeitschritt werden die Teilchen also um eine Distanz auf der Basis der elektromagnetischen Felder propagiert, wobei die Propagationen der Teilchen nicht mehr weiter bestimmt werden, falls diese auf eine Außenseite des umfassenden Luftvolumens (bzw. Teilchenpropagationsvolumens) oder auf ein Ziel treffen. In diesem Fall wird das Teilchen terminiert, wobei die Propagationen anderer Teilchen weiter bestimmt werden können.

Falls in dem Bestimmungsverfahren ein Teilchen auf ein elektrisch Leitendes Bauteil trifft so wird zunächst der bisherige partielle Pfad des Teilchens als partielle Teilchenbahn gespeichert. Hierauf folgend wird eine Mehrzahl von Teilchen, den Sekundärteilchen, an verschiedenen Stellen des Leiters platziert, modellierten elektrisch geladenen Teilchen genannt werden, wobei die weiteren Propagationen dieser Teilchen durch das Verfahren zur Berechnung der Propagation geladener Teilchen weiter bestimmt werden, und wobei Teilchenbahnen zusammengesetzt werden, aus der partiellen Teilchenbahn des Teilchens, welches auf den Leiter getroffen ist, und den neuen partiellen Teilchenbahnen der neuen Teilchen.

Die Positionierung der Sekundärteilchen kann insbesondere wie die Positionierung der Teilchen auf den Quellen erfolgen. Weiterhin werden die Sekundärteilchen von dem Bestimmungsverfahren für Teilchen wie normale Teilchen behandelt, was insbesondere deren Terminierung betrifft.

Das oben beschriebene Vorgehen wird verwendet um zu bestimmen, dass ein geladenes Teilchen instantan durch einen Leiter propagiert.

Falls in dem Bestimmungsverfahren ein Teilchen auf ein elektrisch isolierendes Bauteil trifft, so wird die Teilchenbahn des auf die Oberfläche des elektrisch isolierenden Bauteils projiziert, sodass das Teilchen auf dieser Oberfläche weiter propagieren kann.

Insbesondere kann für diese Projektion die Teilbahn des Teilchens verwendet werden, die aus der Position des Teilchens aus dem letzten Zeitschritt und dem Auftreffpunkt des Teilchens auf der Oberfläche des elektrisch isolierenden Bauteils gebildet wird, wobei mit Hilfe dieser Teilbahn eine Ebene bestimmt wird, die orthogonal zu der Oberfläche des elektrisch isolierenden Bauteils liegt, und wobei die bestimmte Teilbahn auch durch diese orthogonale Ebene verläuft. Weiterhin kann ausgehend von dem Auftreffpunkt des Teilchens auf der Oberfläche des elektrisch isolierenden Bauteils die weitere Teilchenbahn bestimmt werden, die entlang einer Gerade verläuft, die durch den Schnitt der Oberfläche des elektrisch isolierenden Bauteils und der zuvor bestimmten orthogonalen Oberfläche, gebildet wird.

In einer besonders bevorzugten Ausführungsform bestimmten Teilchenbahnen oder partiellen Teilchenbahnen als terminiert bestimmt werden, sobald diese entweder auf ein Ziel treffen oder aus dem umgebenden Luftvolumen (bzw. Teilchenpropagationsvolumens) entweichen; wobei Gesamtpfade aus den Teilchenbahnen und partiellen Teilchenbahnen ermittelt werden, durch Verbinden von partiellen Teilchenbahnen mit den partiellen Teilchenbahnen zugehöriger sekundärer Teilchen, oder durch direktes Bestimmen von Teilchenbahnen, falls das zugehörige Teilchen auf dem Weg von der Quelle zu einem Ziel oder einem Rand des umgebenden Luftvolumens nicht auf ein elektrisch leitfähiges Bauteil aufgetroffen ist; und wobei aus der Gesamtheit der ermittelten Gesamtpfade nur diejenigen berücksichtigt werden, die auf einem Ziel terminieren.

Das Verfahren zum Bestimmen der Propagation von Teilchen wird abgebrochen, wenn alle Teilchen terminiert wurden, oder wenn eine maximale Zeit überschritten wurde, die zuvor gesetzt wurde. Im zweiteren Falle werden die Teilchenbahnen der Teilchen aussortiert, die nicht terminiert wurden.

Durch das oben genannte Vorgehen werde die Bahnen derer Teilchen aussortiert, die kein Ziel erreichen und somit nicht von Interesse für die Bestimmung der Durchschlagstrompfade sind. Die verbleibenden Gesamtbahnen werden in Gruppen eingeordnet, wobei jeweils genau eine Gruppe für die Teilchenbahnen von Teilchen aus einer jeweiligen Startquelle mit einem jeweiligen Ziel besteht. Innerhalb jeder Gruppe wird dann die Gesamtbahn des Teilchens als physikalisch bestimmt, das in der kürzesten Zeit von der Quelle zu dem Ziel Propagiert ist.

In einer besonders bevorzugten Ausführungsform des Verfahrens weisen die modellierten Teilchen eine Masse und eine Ladung auf, wobei der Quotient q/m in einem Bereich zwischen $10^{-1}$ und $10^{-30}$ liegt, sodass sich die Teilchen nahezu ungehindert auf den bestimmten elektrischen Feldlinien bewegen. Hierbei werden allen Teilchen die gleichen Massen und Ladungen zugewiesen, um die Gesamtteilchenbahnen untereinander vergleichbar zu machen.

Die Erfindung kann des Weiteren ein Rechnerprogrammprodukt umfassen, welches ein Programm zum Ausführen des erfindungsgemäßen Bestimmungsverfahrens umfasst. Dabei kann das genannte Programm in den Speicher einer Recheneinheit, insbesondere eines Computers, Clusters oder Servers geladen werden und ausgeführt werden, wobei das Rechnerprogrammprodukt zunächst auf einem portablen Medium gespeichert sein kann.

Des Weiteren umfasst die Erfindung eine Vorrichtung zum Ausführen des Verfahrens zur Bestimmung physikalischer Strompfade.

Diese Vorrichtung ist folglich eine Vorrichtung zum Ermitteln physikalischer Strompfade zwischen mindestens zwei Bauteilen, die mit elektrischen Potentialen beaufschlagt sind, mittels mindestens eines modellierten elektrisch geladenen Teilchens, wobei diese Vorrichtung mindestens eine Bauteilerfassungseinheit, zum Erfassen aller Bauteile, und zur Bestimmung mindestens eines Bauteils als Quelle sowie mindestens eines Zieles; eine Materialbestimmungseinheit zum Bestimmen der Materialien der Bauteile und der umgebenden Luft (bzw. Dielektrikums), wobei insbesondere isolierende und leitende Materialien bestimmbar sind; eine Potentialbeaufschlagungseinheit zum Beaufschlagen der Quelle oder der Quellen und des Ziels oder der Ziele mit Potentialen; eine Positionierungseinheit zum Positionieren von mindestens einem geladenen Teilchens auf einer Quelle, eine Recheneinheit zum Bestimmen der elektromagnetischen Felder und zur anschließenden Propagation der Teilchen, und eine Auswertungseinheit, zum Ermitteln einer oder einer Mehrzahl von physikalischen Teilchenbahnen zwischen der Quelle bzw. den Quellen und dem Ziel bzw. den Zielen, wobei die Teilchenbahnen minimierte Wirkungen aufweisen und wobei zwischen einer jeweiligen Quelle und einem jeweiligen Ziel maximal eine physikalischen Teilchenbahn vorhanden ist, umfasst.

In einer bevorzugten Ausführungsform ist die Vorrichtung ein Computer mit Speicher und einer Bearbeitungseinheit und das Verfahren wie es oben beschrieben wurde, wird als Software auf dem Computer ausgeführt.

## Kurze Beschreibung der Zeichnungen

Im Folgenden wird eine kurze Beschreibung der anhängenden Zeichnungen gegeben.

**Fig 1** zeigt ein allgemeines Ablaufdiagramm einer bevorzugten Ausführung des erfindungsgemäßen Verfahrens, wobei hierbei insbesondere die Schritte S1 des Erstellens eines Modells, S2 des Beaufschlagens zweier oder mehrerer Potentiale, S3 des Positionierens eines oder mehrerer Teilchen, S4 des Bestimmens eines elektrischen Feldes, S5 des Bestimmens von Teilchenbahnen und S6 des Bestimmens eines oder mehrerer Teilchenbahnen dargestellt sind.

**Fig 1A** zeigt ein detailliertes Ablaufdiagramm des ersten Schrittes S1 des erfindungsgemäßen Verfahrens, genauer dem Erstellen eines Modells, wobei hier insbesondere die Unterschritte S1A der CAD Modellerstellung, S1B des Setzens der Materialien, und S1C der Gittererzeugung gezeigt werden.

**Fig 1B** zeigt ein detailliertes Ablaufdiagramm des zweiten Schrittes S3 des erfindungsgemäßen Verfahrens, genauer dem Positionieren eines oder einer Mehrzahl von Teilchen, wobei hier insbesondere die Unterschritte S2A der Bestimmung einer oder einer Mehrzahl von Quellen und S2B dem Positionieren eines oder einer Mehrzahl von Teilchen auf den Quellen gezeigt werden.

**Fig 1C** zeigt ein detailliertes Ablaufdiagramm des ersten Schrittes S6 des erfindungsgemäßen Verfahrens, genauer dem Bestimmen des oder der Gesamtpfade, wobei hier insbesondere die Unterschritte S3A der Berechnungen der/des Gesamtpfade/s, S3B der Sortierung dieser/s Gesamtpfade/s anhand der Startquellen, und S3C der Bestimmung eines physikalischen Pfades je Startquelle gezeigt werden.

**Fig 2** zeigt ein allgemeines Ablaufdiagramm einer bevorzugten Ausführung des erfindungsgemäßen Verfahrens, welches insbesondere die Schritte S1 bis S3 und S6 der in Fig 1, beschriebenen Ausführungsform, umfasst und einen Schritt S45 umfasst, der iterativ die Schritte S4, der E-Feldberechnung und nachfolgend S5 der Teilchenbahnberechnung über eine Mehrzahl von zeitlichen Iterationsschritten umfasst.

**Fig 3** zeigt eine Darstellung eines CAD Modells einer bevorzugten Ausführungsform des erfindungsgemäßen Verfahrens.

**Fig 4** zeigt eine Darstellung eines FEM Gitters einer bevorzugten Ausführungsform des erfindungsgemäßen Verfahrens.

**Fig 5A** zeigt eine Darstellung eines CAD Modells eines umschließenden Luftvolumens einer bevorzugten Ausführungsform des erfindungsgemäßen Verfahrens.

**Fig 5B** zeigt eine Darstellung eines FEM Gitters eines umschließenden Luftvolumens einer bevorzugten Ausführungsform des erfindungsgemäßen Verfahrens.

**Fig 6** zeigt eine Darstellung eines Vergleiches eines herkömmlich bestimmten Pfades KP mit einem physikalischen Pfad S, der mit dem erfindungsgemäßen Verfahren bestimmt wurde.

**Detaillierte Beschreibung der Ausführungsformen**

Im Folgenden werden die bevorzugten Ausführungsformen der Erfindung anhand der Zeichnungen detailliert beschrieben. Dabei sind die Ausführungsformen rein als Mittel zu einer genauen Beschreibung zu verstehen und stellen keinesfalls Beschränkungen oder Einschränkungen der vorliegenden Erfindung dar.

Im Folgenden können die Begriffe "Teilchen" und "geladene Teilchen" synonym behandelt, da die betrachteten Teilchen geladene Teilchen sind. Weiterhin können in den Verfahrensschritten in denen Berechnungen, beschrieben werden auch die Begriffe des modellierten elektrisch geladenen Teilchens und des Teilchens synonym behandelt werden, wobei anzumerken ist, dass in den oben genannten Schritten modellierte elektrisch geladenen Teilchen, d.h. digitalisierte Abbilder elektrisch geladener Teilchen verwendet werden.

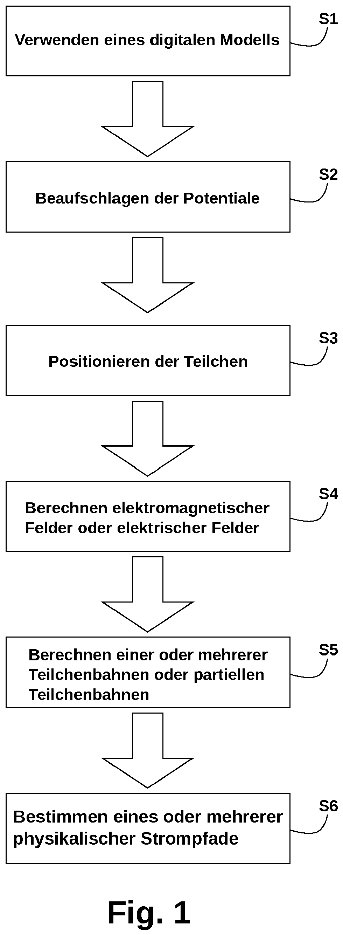

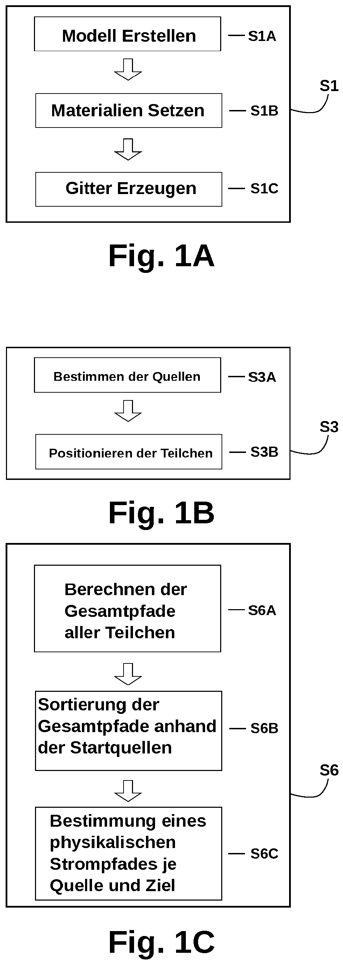

Fig. 1 offenbart eine besonders bevorzugte Ausführungsform der vorliegenden Erfindung, umfassend ein Verfahren zum Bestimmen eines oder mehrerer physikalischer Strompfade, welches aus sechs Schritten bestehen kann, wobei auch Ausführungen mit mehr oder weniger Schritten möglich sind. Genauer gesagt wird in dieser Ausführungsform davon ausgegangen, dass bisher keine Digitalisierungen der realen Bauteile vorliegen.

Ein erster Schritt umfasst das Verwenden (S1) eines digitalen Modells der Bauteile, deren elektromagnetische Materialeigenschaften in dem digitalen Modell gesetzt sind, wobei in dem digitalen Modell ein Luftvolumen (L) vorliegt, welches die Bauteile umgibt, und das Erzeugen räumlicher Gitter auf der Basis des digitalen Modells.

Sollte bereits ein digitalisiertes Modell vorliegen oder ein partielles digitalisiertes Modell, so ist der genannte erste Unterschritt in Bezug auf das digitale Modell der Bauteile ein reiner Verwendungsunterschritt, der gegebenenfalls um einen Modelltransformationsschritt erweitert werden kann, falls beispielsweise das digitale Modell in einem unpassenden Format vorliegt. Eine genauere Beschreibung der Unterschritte folgt.

In einer Ausführungsform wird ein bestehendes digitalisiertes Modell zunächst um ein umgebendes Luftvolumen (bzw. Teilchenpropagationsvolumen) erweitert, welches die inneren Bauteile umgibt und nach außen hin abschließt.

Ein weiterer Schritt umfasst das Beaufschlagen (S2) mindestens zweier der digital modellierten Bauteile mit unterschiedlichen elektrischen Potentialen, wobei mindestens eins der digital modellierten Bauteile als Quelle (Q) bestimmt wird und mindestens ein weiteres als Ziel (Z) bestimmt wird.

Um ein elektrisches Feld zu bestimmen, sind im statischen Falle mindestens zwei Potentiale notwendig, die sich unterscheiden. Dabei laufen die elektrischen Feldlinien von dem höheren Potential zu dem niedrigeren. Im Falle gleicher Potentiale entstehen keine Feldlinien, d.h. das Feld ist im betrachteten Rechengebiet Null.

Potentiale können insbesondere als Randbedingungen an den Oberflächen spezieller (dreidimensionaler) Körper in einer drei-dimensionalen Rechnung, oder an den Kanten spezieller (zweidimensionaler) Körper in einer zwei-dimensionalen Rechnung aufgebracht werden oder als Ladungen an diesen Körpern eingebracht werden.

Es sei angemerkt, dass Feldlinien auch durch äußere Randbedingungen beeinflusst werden können, z.B. durch tangentiale Randbedingungen an einem äußeren Luftvolumen.

Ein weiterer Schritt umfasst das Positionieren (S3) des mindestens einen modellierten elektrisch geladenen Teilchens auf mindestens einem der mit elektrischen Potentialen beaufschlagten digital modellierten Bauteile.

Ein weiterer Schritt umfasst das Bestimmen/Berechnen eines elektrischen Feldes (E) (S4), welches aus den Schritten (S1) und (S2) resultiert, mittels eines numerischen elektromagnetischen Berechnungsverfahrens/Bestimmungsverfahrens. Ein numerisches elektromagnetisches Berechnungsverfahren/Bestimmungsverfahren ist ein Verfahren mit dem elektromagnetische Felder digital berechnet/bestimmt werden.

Elektromagnetische Felder werden im Allgemeinen durch die Maxwellschen Gleichungen und deren Kombinationen und Umformungen beschrieben. Hierbei beschreibt das Gausssche Gesetz die Verteilung des Dielektrischen Feldes **D** um eine Ladung $\rho$ herum

$$\nabla \cdot \mathbf{D} = \rho.$$

Hierdurch entstehen Feldlinien, die von positiven Ladungen weg zeigen und zu negativen Ladungen hin zeigen. Das Gesetz der Abwesenheit Magnetischer Monopole beschreibt, dass es keine Magnetischen Quellen gibt, sodass die Feldlinien der magnetischen Flussdichte **B** immer geschlossen sind

$$\nabla \cdot \mathbf{B} = 0.$$

Das Faradaysche Gesetz beschreibt, dass eine zeitliche Änderung der Magnetischen Flussdichte **B** ein rotierendes Elektrisches Feld erzeugt E

$$\nabla \times \mathbf{E} = -\frac{d\mathbf{B}}{dt}.$$

Das Ampersche Gesetz beschreibt dass eine zeitliche Änderung des Dielektrischen Feldes **D** und /oder ein Strom **J** ein rotierendes Magnetisches Feld erzeugt.

$$\nabla \times \mathbf{H} = \frac{d\mathbf{D}}{dt} + \mathbf{J}$$

Die Maxwellschen Gleichungen (in Kombination mit entsprechenden Materialgesetzen und der Kontinuitätsgleichung) stellen ein vollständiges Gleichungssystem dar und können durch numerische Verfahren approximiert berechnet/bestimmt werden.

In einer besonders bevorzugten Ausführungsform wird ein Finite Elemente, FE, Verfahren zur Berechnung der Felder verwendet. Dabei werden die elektromagnetischen Felder zunächst durch entsprechende Basisfunktionen elementweise approximiert und danach durch Testfunktionen getestet. Im Sinne einer Galerkin Methode kann hierbei eine starke oder schwache Formulierung gewählt werden, wobei in einer schwachen Formulierung, über die entsprechenden Elemente integrierte Werte gebildet werden. In einer besonders bevorzugten Ausführungsform sind die Basis- und Testfunktionen kontinuierlich über die Elementgrenzen hinweg.

In einer möglichen Ausführungsform sind die Basis und / oder Testfunktionen diskontinuierlich über die Elementgrenzen hinweg, sodass ein Diskontinuierliche Galerkin, DG, Verfahren vorliegt.

Sowohl die Approximationsfunktionen (bzw. Basisfunktionen) als auch die Testfunktionen können entweder niedriger Ordnung, z.B. nullter Ordnung, sein, oder bevorzugt auch höherer Ordnung.

In einer bevorzugten Ausführungsform, im Niederfrequenten Bereich sind lediglich statische elektrische Felder von Interesse. Hierbei werden sowohl die magnetischen Felder vernachlässigt, als auch die zeitlichen Veränderungen. Hierdurch ist das berechnet/bestimmte elektrische Feld nach Schritt ein statisches elektrisches Feld.

Ein weiterer Schritt umfasst das Berechnen/Bestimmen einer oder mehrerer Teilchenbahn / en bzw. partiellen Teilchenbahnen (S5), mittels eines Verfahrens zur Berechnung der Propagation geladener Teilchen, wobei die Berechnungen der Teilchenbahnen auf der Basis der Berechnung des elektrischen Feldes (E) aus den Schritten (S3) und (S4) erfolgt. Prinzipiell gehorchen mechanische Teilchen dem Newtonschen Bewegungsgesetz

$$\mathbf{F} = m\,\mathbf{a},$$

das in diesem Fall die Kraft **F** auf ein Teilchen der Masse m und der Beschleunigung **a** beschreibt. Im Falle eines geladenen Teilchens lässt sich diese Kraft als Lorentzkraft

$$\mathbf{F} = q(\mathbf{E} + \mathbf{v} \times \mathbf{B}),$$

spezialisieren. Im Allgemeinen lassen sich hierdurch Aussagen über die Beschleunigung,

$$\mathbf{a}(t) = \frac{q}{m}(\mathbf{E} + \mathbf{v} \times \mathbf{B}),$$

die Geschwindigkeit

$$\mathbf{v}(t) = \frac{q}{m}(\mathbf{E} + \mathbf{v} \times \mathbf{B})t + \mathbf{v_0},$$

und den Ort

$$\mathbf{x}(t) = \frac{q}{2m}(\mathbf{E} + \mathbf{v} \times \mathbf{B})t^2 + \mathbf{v_0}t + \mathbf{x_0}$$

Der Teilchen machen, wobei t die Zeit darstellt. Im Falle vernachlässigter Magnetischer Felder bzw. Magnetischer Flussdichte liegt lediglich die Coulombkraft

$$\mathbf{F} = q\,\mathbf{E}$$

vor, woraus sich vereinfachte Terme für die Beschleunigung,

$$\mathbf{a}(t) = \frac{q}{m}\mathbf{E},$$

die Geschwindigkeit

$$\mathbf{v}(t) = \frac{q}{m}\mathbf{E}\,t + \mathbf{v_0}\,,$$

und den Ort

$$\mathbf{x}(t) = \frac{q}{2m}\mathbf{E}\,t^2 + \mathbf{v_0}t + \mathbf{x_0},$$

ergeben.

In einer besonders bevorzugten Ausführungsform werden die Teilchenbahnen durch ein Particle In Cell, PIC, Verfahren digital berechnet/bestimmt, wobei insbesondere die elektrischen Felder (E) berücksichtigt werden. In alternativen Ausführungsformen können auch Magnetische Felder mit einbezogen werden.

In einem PIC Verfahren werden punktförmige Teilchen digital modelliert, die mindestens einen Ort, eine Geschwindigkeit, eine Masse und eine Ladung aufweisen.

Die Feldwerte werden in dem PIC Verfahren an den Teilchenpositionen interpoliert übergeben oder in diesem ermittelt, um dazu verwendet zu werden, Geschwindigkeiten zu berechnen/bestimmen, mit denen die Teilchen bewegt werden. Hierbei werden sowohl die Orte, als auch die Geschwindigkeiten geupdated. Mögliche Geschwindigkeitsupdateverfahren sind allgemeine Verlet Verfahren oder Boris Verfahren.

Insbesondere bewegen sich die Teilchen bei größeren Feldstärken weiter als bei kleinen Feldstärken. In besonders bevorzugten Ausführungsformen werden modellierte Teilchen gleicher Masse und gleicher Ladung zur Berechnung verwendet, sodass über die Propagationsdauer der Teilchen direkte Rückschlüsse darüber gemacht werden können, welche Teilchen auf einer bevorzugten Bahn propagiert sind, und somit eine Propagation minimalster Wirkung, im Sinne des Lagrangeschen Prinzip, vollzogen haben, und daher auf einer Teilchenbahn propagiert sind, die einem physikalischen Strompfad (S) entspricht. Die Wirkung der Felder auf die Teilchen wird durch den Ladungs- Masse Quotienten q/m der Teilchen beschrieben. In einer besonders bevorzugten Ausführungsform ist der genannte Quotient q/m in einem Bereich zwischen $10^{-1}$ und $10^{-30}$, sodass die Teilchen den Feldlinien fast instantan folgen, d.h. eine sehr geringe Trägheit aufweisen. Bevorzugt wird den Teilchen zum Start keine Initialgeschwindigkeit beaufschlagt, sodass die Teilchen nur durch die elektromagnetischen Felder bewegt werden.

In einer möglichen Ausführungsform der vorliegenden Erfindung können die Zeitschritte des PIC Verfahrens automatisch bestimmt werden und können sich insbesondere auf der Basis von Geometrie-, Gitter- oder Materialeigenschaften ergeben.

Die geladenen Teilchen werden durch das PIC Verfahren in dem Luftvolumen (bzw. Teilchenpropagationsvolumens) propagiert. Durch das Propagieren der Teilchen ergeben sich Teilchenbahnen. Ein weiterer Schritt umfasst das Bestimmen (S6) eines oder mehrerer zurückgelegten / r Gesamtpfade /s des mindestens einen modellierten Teilchens (T) und Bestimmung von resultierenden physikalischen Strompfaden (S), zwischen der oder den Quelle/n (Q) und dem oder den Zielen (Z) .

Fig. 1A zeigt die Unterschritte des Schritts S1, in einer besonders bevorzugten Ausführungsform. Hierbei wird der Schritt des Verwendens S1 in mindestens drei Unterschritte S1A, S1B und S1C unterteilt. Aus darstellungstechnischen Zwecken sind die Unterschritte in einer bestimmten Reihenfolge angegeben; jedoch sind auch andere Reihenfolgen möglich. Insbesondere können die Schritte S1B und S1C in vertauschter Reihenfolge vorliegen.

In Unterschritt S1A wird dabei ein digitalisiertes Modell erstellt, das insbesondere ein "Computer Aided Design", CAD, Modell sein kann. Ein digitales CAD Modell, ist ein approximatives, digitales Abbild der Realität. Dabei können insbesondere Bauteile über deren Facettenkörper abgebildet werden.

Zur Erstellung des digitalen Modells kommen insbesondere die Programme DesignModeler der Firma ANSYS, sowie andere Design Programme der Firma ANSYS; CATIA der Firma Dassault, sowie andere Design Programme der Firma Dassault, insbesondere SOLIDWORKS; und die Programme NX und "Simcenter", SC, der Firma Siemens, sowie andere Design Programme der Firma Siemens, in Frage. Bevorzugt kommt jedoch das Programm NX / SC der Firma Siemens in Frage.

Dabei können drei-dimensionale oder zwei-dimensionale CAD Modelle vorliegen. In einem drei-dimensionalen CAD Modell existieren Volumenkörper, d.h. 3D Körper, Oberflächen, d.h. 2D Körper, Linien oder Liniensegmente oder Kurven, d.h. 1D Körper, und Punkte, d.h. 0D Körper.

In einer besonders bevorzugten Ausführungsform ist das CAD Programm zur Erstellung der CAD Geometrien eins der Programme Siemens NX bzw. Siemens Simcenter.

In einer Ausführungsform ist weiterhin denkbar, dass bereits ein digitalisiertes CAD Modell vorliegt und verwendet werden kann; oder das dieses Modell durch ein Transformationsprogramm transformiert wird.

In der obigen besonders bevorzugten Ausführungsform wird in einem weiteren Unterschritt S1B eine Gittererzeugung vorgenommen. Insbesondere kann hierbei ein Gitter basierend auf einer reinen Delaunay Triangulation vorgenommen werden, in der das Gitter durch Tetrahedra approximiert wird, oder eines anderen Gittererzeugungsverfahrens. Insbesondere sind Gittererzeugungen unterstützt, in denen Hexaeder, Pyramiden und Prismen verwendet werden, sowie Dreiecke, Rechtecke, Linien und Punkte. Des Weiteren sind Gitteradaptionsverfahren möglich, sodass der Unterschritt des Erzeugens entsprechender räumlicher Gitter eventuell mehrmals durchgeführt wird.

In einem weiteren Teilschritt S1C werden Materialeigenschaften und insbesondere elektromagnetische Materialeigenschaften in das digitale Modell und / oder Gitter Model übertragen. Hierbei wird insbesondere die elektrische Permitivität ε aufgebracht, die die Relation des elektrischen Feldes zum dielektrischen Verschiebungsfeld beschreibt

$$\varepsilon \cdot \mathbf{E} = \mathbf{D}.$$

Des Weiteren wird auch die Permeabilität μ aufgebracht, die die Relation des Magnetischen Feldes zur Magnetischen Flussdichte beschreibt

$$\mu \cdot \mathbf{H} = \mathbf{B}.$$

Außerdem wird die Leitfähigkeit σ aufgebracht, die in Kombination mit dem elektrischen Feld und aufgebrachten Strömen $\mathbf{J}_s$ den Gesamtstrom $\mathbf{J}$ beschreibt

$$\sigma \cdot \mathbf{E} + \mathbf{J}_s = \mathbf{J}.$$

Als Materialien kommen elektrische leitende, Materialien wie Kupfer oder Graphit, in Frage sowie elektrisch isolierende Materialien, wie Glas oder Plastik. Insbesondere wird jedoch Luft oder ein anderes passendes Dielektrikum benötigt, da die geladenen Teilchen primär in einem Luftvolumen propagiert werden.

Fig. 1B. zeigt die Unterschritte des Schrittes S3 in einer besonders bevorzugten Ausführungsform der vorliegenden Erfindung, wobei hier mindestens zwei Unterschritte S3A und S3B vorliegen.

In Unterschritt S3A wird mindestens eine Quelle (Q) bestimmt, auf der ein positives elektrisches Potential, wie z.B. 1V, aufgebracht wird. Des Weiteren wird mindestens ein Ziel (Z) bestimmt, auf das ebenfalls ein Potential aufgebracht wird, wobei dieses zweite Potential kleiner als das erste Potential ist, z.B. 0V. Anhand des Gausschen Gesetzes lassen sich elektrische Feldlinien berechnen/bestimmen.

In Ausführungsformen können weiterhin mehrere Bauteile als Quellen bestimmt werden. Dabei sollten unterschiedliche Quellen disjunkt zueinander sein und nicht durch einen Leiter verbunden sein.

In einer Ausführungsform sind weiterhin mehrere Bauteile als Ziele bestimmt, die ebenfalls wie auch die Quellen disjunkt zu einander sein sollten und nicht miteinander durch Leiter verbunden sein sollten.

In einer Ausführungsform sind weiterhin Bauteile als Quellen und / oder mehrere Bauteile als Ziele bestimmt, die ebenfalls jeweils disjunkt zu einander sein sollten und nicht miteinander durch Leiter verbunden sein sollten.

In Unterschritt S3B wird mindestens ein Teilchen auf einer Quelle Platziert. Diese Position stellt für das geladene Teilchen eine Startposition dar.

In einer besonders bevorzugten Ausführungsform wird in Schritt (S3) eine Mehrzahl von modellierten elektrisch geladenen Teilchens (T1...TN) an unterschiedlichen Stellen der mindestens einen Quelle positioniert.

In besonders bevorzugten Ausführungsformen wird eine Vielzahl von modellierten elektrisch geladenen Teilchen auf den Oberflächen, den Außenkanten und den Außenpunkten einer oder aller Quellen platziert. Insbesondere ist eine äquidistante Platzierung bevorzugt, sodass eine Vielzahl von modellierten elektrisch geladenen Teilchen gleichmäßig auf der oder den Quelle / n platziert ist / sind. Weiterhin sind jedoch auch andere Platzierungsmöglichkeiten denkbar, insbesondere manueller Platzierungen durch den Anwender.

Wenn beispielsweise, Durchschlagstrompfade, von einer Quelle zu einem oder mehreren Zielen zu bestimmen sind; wird eine Quelle bestimmt und bevorzugt mit mehreren modellierten elektrisch geladenen Teilchen beaufschlagt.

Wenn jedoch beispielsweise Durchschlagstrompfade von mehreren Quelle zu einem oder mehreren Zielen zu bestimmen sind, werden mehrere Quelle bestimmt und mit einem oder mehreren modellierten elektrisch geladenen Teilchen beaufschlagt, wobei in diesem Falle die Startidentifizierungen der Teilchen bestimmt werden, um für jedes Teilchen festzuhalten, d.h. zu speichern, von welcher Quelle dieses gestartet wird.

In einer Ausführungsform wird eine Vielzahl von Teilchen auf jeder Oberfläche jeder Quelle und auf jeder Kante jeder Quelle Platziert. Dabei werden die Quellen der jeweiligen Teilchen notiert. Es ist jedoch auch denkbar nur ein Teilchen auf einer Quelle zu platzieren.

Fig. 1C. zeigt die Unterschritte des Schrittes S6 in einer besonders bevorzugten Ausführungsform der vorliegenden Erfindung, wobei hier mindestens drei Unterschritte S6A S6B und S6C vorliegen.

In Unterschritt S6A werden in einer besonders bevorzugten Ausführungsform die Gesamtpfade der jeweiligen Teilchen berechnet/bestimmt. Dabei dienen die Startpositionen der Teilchen auf den Quellen zunächst als Startwerte, wobei die Teilchen von den Startpositionen aus propagiert werden und sich in jedem Zeitschritt bewegen, falls ein Elektrisches Feld vorhanden ist.

Die Teilchen bewegen sich bei größeren Feldstärken weiter als bei kleinen Feldstärken, wobei dieses Verhalten direkt die maximierte Wirkung dieser Felder wiederspiegelt. Mit anderen Worten gesagt bewegen sich die Teilchen bevorzugt auf starken Feldlinien.

Falls ein Teilchen auf einen Isolator trifft, so kann es sich durch entsprechende Einstellungen auf dessen äußerer, d.h. der Luft zugewandten Seite bewegen. Hierbei wird die bisherige Teilchenbahn auf die Oberfläche des Isolators projiziert und dort fortgesetzt.

Für die Projektion kann beispielsweise die Teilbahn des Teilchens verwendet werden, die aus der Position des Teilchens aus dem letzten Zeitschritt und dem Auftreffpunkt des Teilchens auf der Oberfläche des elektrisch isolierenden Bauteils gebildet wird, wobei mit Hilfe dieser Teilbahn eine Ebene berechnet/bestimmt wird, die orthogonal zu der Oberfläche des elektrisch isolierenden Bauteils liegt, und wobei die berechnete/bestimmte Teilbahn auch durch diese orthogonale Ebene verläuft. Weiterhin kann ausgehend von dem Auftreffpunkt des Teilchens auf der Oberfläche des elektrisch isolierenden Bauteils die weitere Teilchenbahn berechnet/bestimmt werden, die entlang einer Gerade verläuft, die durch den Schnitt der Oberfläche des elektrisch isolierenden Bauteils und der zuvor berechnet/bestimmten orthogonalen Oberfläche, gebildet wird.

Falls in dem Berechnungsverfahren/Bestimmungsverfahren ein Teilchen auf ein elektrisch Leitendes Bauteil trifft so wird zunächst der bisherige partielle Pfad des Teilchens als partielle Teilchenbahn gespeichert. Hierauf folgend wird eine Mehrzahl von Teilchen an verschiedenen Stellen des Leiters platziert, modellierten elektrisch geladenen Teilchen genannt werden, wobei die weiteren Propagationen dieser Teilchen durch das Verfahren zur Berechnung der Propagation geladener Teilchen weiter berechnet/bestimmt werden, und wobei Teilchenbahnen zusammengesetzt werden, aus der partiellen Teilchenbahn des Teilchens, welches auf den Leiter getroffen ist, und den neuen partiellen Teilchenbahnen der neuen Teilchen.

Die Positionierung der Sekundärteilchen kann insbesondere wie die Positionierung der Teilchen auf den Quellen erfolgen. Weiterhin werden die Sekundärteilchen von dem Berechnungsverfahren/Bestimmungsverfahren für Teilchen wie normale Teilchen behandelt, was insbesondere deren Terminierung betrifft.

Das oben beschriebene Vorgehen wird verwendet um zu berechnen/bestimmen, dass ein geladenes Teilchen instantan durch einen Leiter propagiert, wobei ein Teilchen auch mehrmals auf einen oder mehrere Leiter auftreffen kann. In diesem Fall können folglich mehr als eine partielle Teilchenbahn entstehen.

Ein Teilchen gilt als terminiert, wenn es sich aus dem Luftvolumen (bzw. Teilchenpropagationsvolumen) über dessen Außenkanten herausbewegt oder wenn es auf ein Ziel auftrifft. Für die Gesamtheit der Gesamtpfade werden nur die Pfade derer Teilchen berücksichtigt, die von einer Quelle aus starten und in einem Ziel terminieren. Diese Gesamtheit kann auch Gesamtpfade umfassen die aus Teilpfaden, z.B. zu / von einem Leiter hin / her, zusammengesetzt sind, umfassen.

Hierbei werden Gesamtpfade aus den Teilchenbahnen und partiellen Teilchenbahnen ermittelt, durch Verbinden von partiellen Teilchenbahnen mit den partiellen Teilchenbahnen zugehöriger sekundärer Teilchen, oder durch direktes Bestimmen von Teilchenbahnen falls das zugehörige Teilchen auf dem Weg von der Quelle zu einem Ziel oder einem Rand des umgebenden Luftvolumens nicht auf ein elektrisch leitfähiges Bauteil aufgetroffen ist; und wobei aus der Gesamtheit der ermittelten Gesamtpfade nur diejenigen berücksichtigt werden, die auf einem Ziel terminieren.

Das Verfahren zum Berechnen/Bestimmen der Propagation von Teilchen wird abgebrochen wenn alle Teilchen terminiert wurden, oder wenn eine maximale Zeit überschritten wurde, die zuvor gesetzt wurde. Im zweiteren Falle werden die Teilchenbahnen der Teilchen aussortiert, die nicht terminiert wurden.

Durch das oben genannte Vorgehen werden die Bahnen derer Teilchen aussortiert, die kein Ziel erreichen und somit nicht von Interesse für die Bestimmung der Durchschlagstrompfade sind. Die verbleibenden Gesamtbahnen werden in Gruppen eingeordnet, wobei jeweils genau eine Gruppe für die Teilchenbahnen von Teilchen aus einer jeweiligen Startquelle mit einem jeweiligen Ziel besteht. Innerhalb jeder Gruppe wird dann die Gesamtbahn des Teilchens als physikalisch bestimmt das in der kürzesten Zeit von der Quelle zu dem Ziel propagiert ist.

In Unterschritt S6B wird die Gesamtheit der ermittelten Gesamtpfade anhand der Quellen und Ziele sortiert und gruppiert, wobei eine Gruppe die Gesamtpfade aller Teilchen von einer bestimmten Quelle zu einem bestimmten Ziel enthält.

In Unterschritt S6C wird, jeweils maximal ein Gesamtpfad von einer Quelle zu einem Ziel bestimmt. Es sei angemerkt, dass es vorkommen kann, dass kein Pfad von einer bestimmten Quelle zu einem bestimmten Ziel besteht. Dies kommt, z.B. vor wenn ein Isolator das Luftvolumen zwischen Quelle und Ziel trennt. Bei den ermittelten Gesamtpfaden zwischen einer Quelle und einem Ziel wird die jeweilige gesamte Reisedauer des zugehörigen Teilchens bestimmt; weiterhin werden die Teilchenbahnen nach deren Reisedauern sortiert. Der Gesamtpfad des Teilchens mit der geringsten Reisedauer ist dabei der Pfad mit der geringsten Wirkung, nach dem Prinzip von Lagrange, und wird folglich als physikalischer Pfad bestimmt. Sollten mehrere gleichlange Pfade vorliegen, werden diese dem Anwender angezeigt, um eine semi-manuelle Auswahl zu treffen.

In einer besonders bevorzugten Ausführungsform wird das elektrische Feld nur einmal, zu Anfang des Verfahrens berechnet/bestimmt in dem Feldberechnungsschritt S4 und nur einmal an das PIC Verfahren in Schritt S5 übergeben. Dies dient der CPU- und Arbeitsspeichereffizienz. In diesem Fall kann insbesondere ein statisches elektrisches Feld vorliegen.

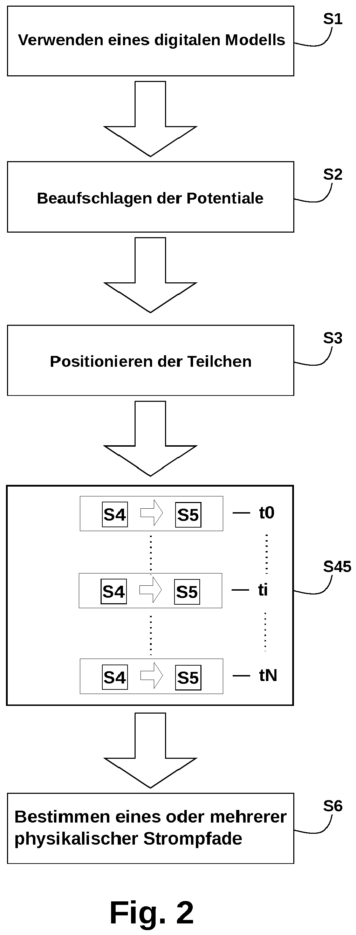

Fig. 2 zeigt die Schritte eines abgewandelten Berechnungsverfahren/Bestimmungsverfahrens nach einer weiteren Ausführungsform der vorliegenden Erfindung. Hierin können die Schritte S1, S2, S3 und S6 in der gleichen Art wie zuvor beschrieben vorliegen, wobei jegliche zuvor genannten Kombinationen oder Ausführungen möglich sind.

In der genannten Ausführungsform wird ein zeitabhängiges elektrisches Feld oder elektromagnetische Felder angenommen, daß / die entweder aus einer Elektrodynamischen bzw. Elektroquasistatischen Lösung, einer Magnetodynamischen bzw. Magnetoquasistatischen Lösung oder einer Wellen Lösung berechnet/bestimmt wird.

In einer bevorzugten Ausführungsform wird das Magnetische Feld und die Magnetische Flussdichte nur in der Feldberechnung betrachtet.

In einer Ausführungsform wird das Magnetische Feld und die Magnetische Flussdichte sowohl in der Feldberechnung als auch im PIC Verfahren verwendet.

In einer Ausführungsform wird das Feld bzw. werden die Felder zu jedem Zeitschritt (oder zu einer Vielzahl von Zeitschritten) berechnet/bestimmt und an das PIC Verfahren übergeben. Folglich werden die Schritte S4 und S5 zu einem kombinierten Schritt S45 zusammengefasst, der zu jedem betrefflichen Zeitschritt ausgeführt wird. Hierbei ist es auch möglich, dass es mehr Teilchenbewegungsschritte, d.h. S5, gibt als Feldschritte, sodass die Feldwerte über gewisse Zeitspannen hin als konstant angenommen werden und das PIC Verfahren Unterzeitschritte ausführen kann.

In einer denkbaren Ausführungsform kann das Verfahren zur Berechnung des elektrischen Feldes (E) nach Schritt (S4) auch ein Finite Differenzen, FD, Verfahren sein.

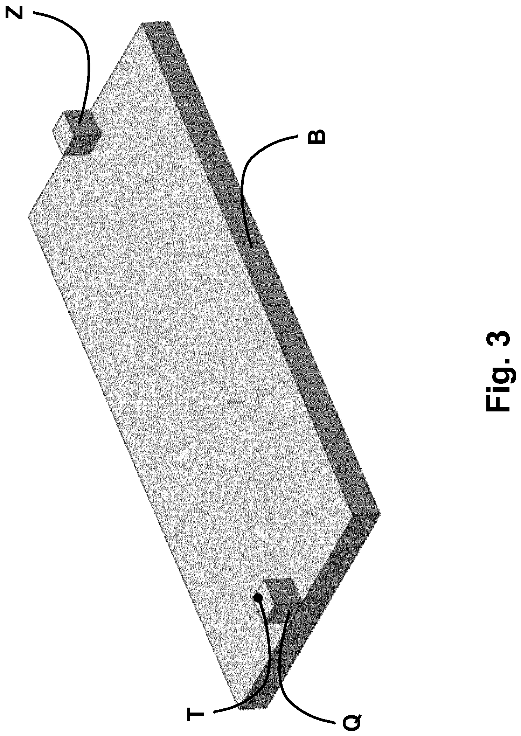

Fig. 3 zeigt ein drei-dimensionales CAD Modell eines Ausführungsbeispiels der vorliegenden Erfindung. Das CAD Modell umfasst drei Bauteile, eine Quelle (Q), ein Ziel (Z) und ein weiteres Bauteil (B), welches als insbesondere als Isolator angenommen werden kann. Im Sinne eines Erfindungsgemäßen Verfahrens wird zu einem späteren Schritt ein Teilchen (T) auf der Quelle (Q) platziert.

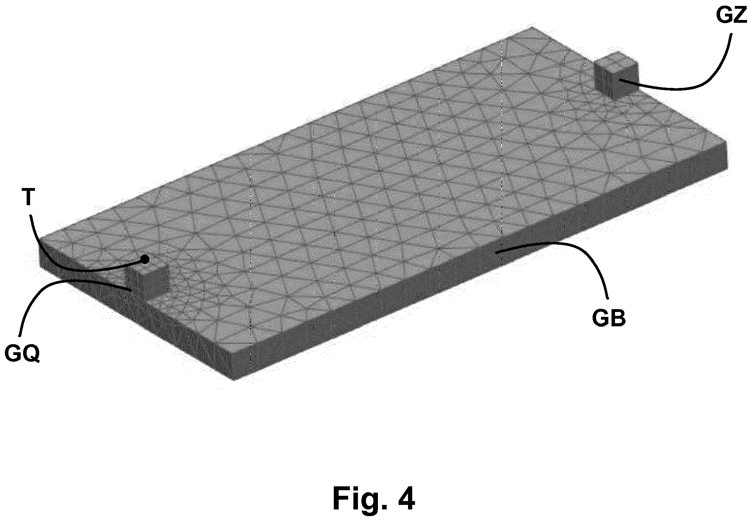

Fig. 4 zeigt eine Triangulation des CAD Modells aus Fig.3. Hierbei entstehen drei Gitter, jeweils für die Quelle (GQ), für das Ziel (GZ) und für das Bauteil (GB).

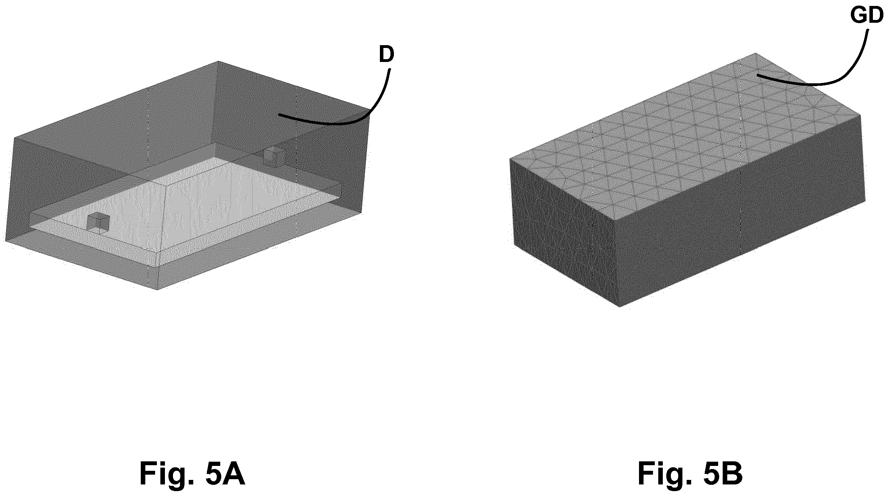

Fig. 5A und Fig. 5B zeigen jeweils die Baugruppe aus Fig. 3 und die triangulierte Baugruppe aus Fig. 4 mit einem zusätzlichen, umgebenden Luftvolumen bzw. einer Triangulation des umgebenden Luftvolumens.

Wie zuvor beschrieben ist das Luftvolumen (bzw. Teilchenpropagationsvolumen) notwendig, um die Teilchen mit dem PIC Verfahren zu propagieren.

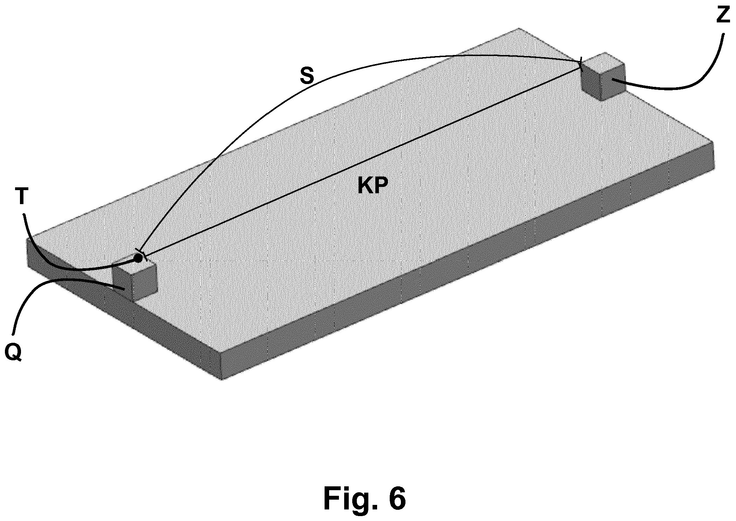

Fig. 6 zeigt den resultierenden Teilchenpfad (S) des Berechnungsverfahren/Bestimmungsverfahrens, unter der Annahme, dass die Quelle mit 1V beaufschlagt wurde und das Ziel mit 0V beaufschlagt wurde. Im Vergleich dazu ist der kürzeste Pfad (KP) dargestellt, der mit einem herkömmlichen Verfahren ermittelt würde. Der physikalische Strompfad (S) ist hierbei bogenförmig und länger als der kürzeste Pfad (KP) der als sicherer Pfad angenommen wird. Folglich können in einem folgenden Designschritt die Quelle (Q) und das Ziel (Z) näher zusammengerückt werden, bis der Strompfad (S) die gleiche Länge wie der Sicherheitspfad (KP) aufweist. Das Verfahren muss hierbei folglich mehrfach angewandt werden.

In einer bevorzugten Ausführungsform wird weiterhin ein Rechnerprogrammprodukt bereitgestellt, das ein Programm zum Ausführen eines Berechnungsverfahren/Bestimmungsverfahrens einer der vorherigen Ausführungsformen oder einer Kombination daraus umfasst.

Das Programm kann dabei auf einem mobilen Medium, wie einer CD einer DVD eines USB Sticks, oder einer Festplatte gespeichert sein oder übereinen Internetzugang herunterladbar sein.

Des Weiteren kann das genannte Programm in den Speicher einer Recheneinheit, insbesondere eines Computers, Clusters oder Servers geladen werden und ausgeführt werden.

In einer weiteren Ausführungsform wird weiterhin eine Vorrichtung (10) zum Ausführen des Verfahrens (1) zum Bestimmen physikalischer Strompfade offenbahrt.

Hierbei kann die Vorrichtung auch eine ein Vorrichtung (10) zum Ermitteln eines oder mehrerer physikalischer Strompfade (S) zwischen mindestens zwei Bauteilen, die mit elektrischen Potentialen beaufschlagt sind, mittels mindestens eines modellierten elektrisch geladenen Teilchens (T), offenbart. Dabei kann die Vorrichtung (10) bis zu sechs Einheiten umfassen.

Insbesondere kann die Vorrichtung (10) eine Bauteilerfassungseinheit (B1), zum Erfassen aller Bauteile, und zur Bestimmung mindestens eines Bauteils als Quelle (Q) sowie mindestens eines Zieles (Z) aufweisen. Des Weiteren ist auch die Erfassung mehrerer Ziele und / oder Quellen möglich, sowie der Definition eines Umgebenden Luftvolumens (L) (bzw. Teilchenpropagationsvolumens), dass alle Bauteile umgibt.

Weiterhin umfasst die Vorrichtung (10) eine Materialbestimmungseinheit (B2), zum Bestimmen der Materialien der Bauteile und der umgebenden Luft, wobei insbesondere isolierende und leitende Materialien bestimmbar sind.

Des Weiteren umfasst die Vorrichtung (10) eine Potentialbeaufschlagungseinheit (B3) zum Beaufschlagen der Quelle oder der Quellen und des Ziels oder der Ziele mit Potentialen, wobei Quellen mit höheren Potentialen beaufschlagt werden als die Ziele, sodass sich Feldlinien von den Quellen zu den Zielen hin ausbreiten.

Weiterhin umfasst die Vorrichtung (10) eine Positionierungseinheit (B4) zum Positionieren von mindestens einem geladenen Teilchens auf einer Quelle (Q), wobei auch mehrere Teilchen auf der oder den Quelle/n platziert werden kann / können. Außerdem kann die Positionierungseinheit (B4) zu folgenden Zeiten, also Zeiten, die nicht der Initialzeit entsprechen, auch Sekundäre Teilchen auf Leitern, insbesondere auf der Oberfläche oder auf Außenkanten von Leitern, platzieren, wenn diese von einem Teilchen getroffen wurden.

Außerdem umfasst die Vorrichtung (10) eine Recheneinheit (B5) zum Berechnen/Bestimmen der elektromagnetischen Felder und zur anschließenden Propagation der Teilchen. Dabei können sowohl statische als auch dynamische Feldberechnungen vorliegen, die die Magnetischen Felder miteinbeziehen können, aber nicht müssen.

Weiterhin umfasst die Vorrichtung (10) eine Auswertungseinheit (B6), zur Ermittlung einer oder einer Mehrzahl von physikalischen Teilchenbahnen zwischen der Quelle bzw. den Quellen und dem Ziel bzw. den Zielen, wobei die Teilchenbahnen minimierte Wirkungen aufweisen und wobei zwischen einer jeweiligen Quelle und einem jeweiligen Ziel maximal eine physikalische Teilchenbahn vorhanden ist.

Hierbei kann ein manuelles Interface zum Benutzer vorgesehen sein, das den physikalischen Weg ausgibt und anzeigt. Des Weiteren kann das Interface interaktiv sein, um insbesondere beim Vorliegen einer Mehrzahl äquivalenter physikalischer Wege dem Benutzer eine manuelle Auswahl zu ermöglichen.

**Symbolverzeichnis**

**1** Berechnungsverfahren/Bestimmungsverfahren
**10** Vorrichtung

**S1** Schritt 1: Erstellen eines Modells
**S2** Schritt 2: Beaufschlagen der Potentiale
**S3** Schritt 3: Positionieren der Teilchen
**S4** Schritt 4: Berechnen/Bestimmen des elektrischen Feldes oder der elektromagnetischen Felder
**S5** Schritt 5: Berechnen/Bestimmen der Teilchenbahnen
**S6** Schritt 6: Bestimmen des Gesamtpfades

**S1A** Unterschritt 1A: Erstellen eines CAD Modells
**S1B** Unterschritt 1B: Setzen der Materialeigenschaften
**S1C** Unterschritt 1C: Erzeugen der Gitter

**S3A** Unterschritt 3A: Bestimmen der Quellen
**S3B** Unterschritt 3B: Positionieren der Teilchen auf der Quelle / den Quellen

**S6A** Unterschritt 6A: Berechnen/Bestimmen aller Teilchengesamtpfade
**S6B** Unterschritt 6B: Sortierung der Gesamtpfade
**S6C** Unterschritt 6C: Bestimmung eines physikalischen Gesamtpfades pro Quelle

**S45** Schritt 45:Iterativer Schritt, als iterative Kombination der Schritte S4 und S5

**Q** Quelle
**GQ** Gitter Quelle
**Z** Ziel

**GZ** Gitter Ziel

**B** Bauteil
**GB** Gitter Bauteil

**D** Dielektrikum
**GD** Gitter Dielektrikum

**L** Luftvolumen (bzw. Teilchenpropagationsvolumens)

**T** Teilchen
**S** Physikalischer Teilchengesamtpfad / Strompfad
**KP** Kürzester Pfad

**m** Teilchen-Masse
**q** Teilchen-Ladung

**B1** Bauteilerfassungseinheit
**B2** Materialbestimmungseinheit
**B3** Potentialbeaufschlagungseinheit
**B4** Positionierungseinheit
**B5** Recheneinheit
**B6** Auswertungseinheit

**Patentansprüche**

1. Verfahren (1) zum Bestimmen eines oder mehrerer physikalischer Strompfade (S) zwischen mindestens zwei Bauteilen, die mit elektrischen Potentialen beaufschlagt sind, zur Erkennung und/oder Vermeidung von Spannungsdurchschlägen zwischen den Bauteilen, mittels mindestens eines elektrisch geladenen Teilchens (T), umfassend die Schritte:

   Verwenden (S1) eines digitalen Modells der Bauteile, deren elektromagnetische Materialeigenschaften in dem digitalen Modell gesetzt sind, wobei in dem digitalen Modell ein Luftvolumen (L) bzw. Teilchenpropagationsvolumens vorliegt, welches die Bauteile umgibt, und dem Erzeugen räumlicher Gitter auf der Basis des digitalen Modells;
   Beaufschlagen (S2) mindestens zweier der digital modellierten Bauteile mit unterschiedlichen elektrischen Potentialen, wobei mindestens eins der digital modellierten Bauteile als Quelle (Q) bestimmt wird und mindestens ein weiteres als Ziel (Z) bestimmt wird;
   Positionieren (S3) des mindestens einen modellierten elektrisch geladenen Teilchens (T) auf mindestens einem der mit elektrischen Potentialen beaufschlagten digital modellierten Bauteile;
   Bestimmen elektromagnetischer Felder (S4), aus den Schritten (S1) und (S2), und insbesondere eines elektrischen Feldes (E) mittels eines numerischen elektromagnetischen Bestimmungsverfahrens;

Bestimmen einer oder mehrerer Teilchenbahn / en bzw. partiellen Teilchenbahnen (S5), mittels eines Verfahrens zur Berechnung der Propagation geladener Teilchen, wobei die Berechnungen der Teilchenbahnen auf der Basis der Berechnung des elektrischen Feldes (E) aus den Schritten (S3) und (S4) erfolgt; und

Bestimmen (S6) eines oder mehrerer zurückgelegten / r Gesamtpfade /s des mindestens einen modellierten Teilchens (T) und Bestimmung von resultierenden physikalischen Strompfaden (S), zwischen der oder den Quelle/n (Q) und dem oder den Zielen (Z).

2. Verfahren nach Anspruch 1, **dadurch gekennzeichnet, dass** in Schritt (S3) genau ein modelliertes elektrisch geladenes Teilchen (T) auf einer Außenfläche einer Quelle positioniert wird.

3. Verfahren nach Anspruch 1, **dadurch gekennzeichnet, dass** in Schritt (S3) eine Mehrzahl von modellierten elektrisch geladenen Teilchens (T1...TN) an unterschiedlichen Stellen der mindestens einen Quelle positioniert werden.

4. Verfahren nach Anspruch 3, **dadurch gekennzeichnet, dass** eine Mehrzahl von Quellen (Q) und / oder eine Mehrzahl von Zielen (Z) vorliegt, wobei auf jeder dieser Quellen mindestens ein modelliertes elektrisch geladenes Teilchen (T) positioniert ist.

5. Verfahren nach einem der vorherigen Ansprüche, **dadurch gekennzeichnet, dass**

das bestimmte elektrische Feld nach Schritt (S4) ein statisches elektrisches Feld ist, oder, dass
das bestimmte elektrische Feld nach Schritt (S4) ein zeitabhängiges elektrisches Feld ist und dass die Schritte S4 und S5 zu einem Schritt S45 zusammengefasst werden, und ein zeitliches Iterationsverfahren über diesen Schritt S45 verwendet wird.

6. Verfahren nach einem der vorherigen Ansprüche, **dadurch gekennzeichnet, dass** mindestens ein Bauteil mit einem elektrisch isolierenden Material vorliegt; und, dass

falls bei der Berechnung der Teilchenpropagation/en ein oder mehrere Teilchen, auf eine Oberfläche eines elektrisch isolierenden Bauteils auftreffen, diese Propagationsrichtung/en der Teilchen umgerechnet werden, um sich auf der Oberfläche des elektrisch isolierenden Bauteils entlang der bisherigen Propagationsrichtung/en zu bewegen.

7. Verfahren nach einem der vorherigen Ansprüche, **dadurch gekennzeichnet, dass** mindestens ein Bauteil mit einem elektrisch leitfähigen Material vorliegt; und, dass

falls bei der Berechnung der Teilchenpropagation/en ein oder mehrere Teilchen, auf eine Oberfläche eines elektrisch leitfähigen Bauteils auftreffen, die bisherige/n Teilchenbahn/en dieses/r als partielle Teilchenbahn/en gespeichert werden; wobei
darauf folgend an unterschiedlichen Stellen des elektrisch leitfähigen Bauteils, modellierte elektrisch geladene Sekundärteilchen positioniert werden, deren Propagationen, mittels des Verfahrens zur Berechnung der Propagation geladener Teilchen, bestimmt werden.

8. Verfahren nach einem der vorherigen Ansprüche, **dadurch gekennzeichnet, dass** das Verfahren zur Berechnung der Propagation geladener Teilchen aus Schritt (S5) ein Particle In Cell, PIC, Verfahren ist, wobei mit diesem Verfahren, auf der Basis eines bestimmten elektrischen Feldes aus Schritt (S3), die Bahnen elektrisch geladener Teilchen bestimmt werden.

9. Verfahren nach einem der vorherigen Ansprüche, **dadurch gekennzeichnet, dass** die bestimmten Teilchenbahnen oder partiellen Teilchenbahnen als terminiert bestimmt werden, sobald diese entweder auf ein Ziel (Z) treffen oder aus dem umgebenden Luftvolumen (L) entweichen; wobei Gesamtpfade aus den Teilchenbahnen und partiellen Teilchenbahnen ermittelt werden, durch Verbinden von partiellen Teilchenbahnen mit den partiellen Teilchenbahnen zugehöriger sekundärer Teilchen, oder durch direktes Bestimmen von Teilchenbahnen falls das zugehörige Teilchen auf dem Weg von der Quelle (Q) zu einem Ziel (Z) oder einem Rand des umgebenden Luftvolumens (L) nicht auf ein elektrisch leitfähiges Bauteil aufgetroffen ist; und wobei aus der Gesamtheit der ermittelten Gesamtpfade nur diejenigen berücksichtigt werden, die auf einem Ziel (Z) terminieren.

10. Verfahren nach einem der vorherigen Ansprüche, **dadurch gekennzeichnet, dass**

das Verfahren zur Berechnung der elektromagnetischen Felder und insbesondere des elektrischen Feldes (E) nach Schritt (S4) ein Finite Elemente, FEM, Verfahren ist oder dass
das Verfahren zur Berechnung der elektromagnetischen Felder und insbesondere des elektrischen Feldes (E) nach Schritt (S4) ein Finite Differenzen, FD, Verfahren ist.

11. Verfahren nach einem der vorherigen Ansprüche, **dadurch gekennzeichnet, dass** die modellierten Teilchen einen Masse (m) aufweisen und eine Ladung (q) und wobei der Quotient q/m in einem Bereich zwischen $10^{-1}$ und $10^{-30}$ liegt, sodass sich die Teilchen nahezu ungehindert auf den bestimmten elektrischen Feldlinien zu bewegen.

12. Verfahren nach einem der vorherigen Ansprüche, **dadurch gekennzeichnet, dass** aus der Gesamtheit der zurückgelegten Gesamtpfade der Teilchen (T1...TN) maximal jeweils ein Gesamtpfad zwischen jeder Quelle (Q) und jedem Ziel (Z) bestimmt wird, der die kleinste Wirkung hat.

13. Vorrichtung (10) **gekennzeichnet, durch** eine Einrichtung und Ausbildung zum Ausführen des Verfahrens (1) zum Bestimmen eines oder mehrerer physikalischen Strompfade / s (S) nach einem oder mehreren der vorhergehenden Verfahrensansprüche.

Verwenden eines digitalen Modells — S1

Beaufschlagen der Potentiale — S2

Positionieren der Teilchen — S3

Berechnen elektromagnetischer Felder oder elektrischer Felder — S4

Berechnen einer oder mehrerer Teilchenbahnen oder partiellen Teilchenbahnen — S5

Bestimmen eines oder mehrerer physikalischer Strompfade — S6

## Fig. 1

| | |
|---|---|
| **Modell Erstellen** | — S1A |
| ⇓ | |
| **Materialien Setzen** | — S1B |
| ⇓ | |
| **Gitter Erzeugen** | — S1C |

S1

# Fig. 1A

| | |
|---|---|
| **Bestimmen der Quellen** | — S3A |
| ⇓ | |
| **Positionieren der Teilchen** | — S3B |

S3

# Fig. 1B

| | |
|---|---|
| **Berechnen der Gesamtpfade aller Teilchen** | — S6A |
| ⇓ | |
| **Sortierung der Gesamtpfade anhand der Startquellen** | — S6B |
| ⇓ | |
| **Bestimmung eines physikalischen Strompfades je Quelle und Ziel** | — S6C |

S6

# Fig. 1C

Verwenden eines digitalen Modells — S1

Beaufschlagen der Potentiale — S2

Positionieren der Teilchen — S3

S4 ⇒ S5 — t0

S4 ⇒ S5 — ti — S45

S4 ⇒ S5 — tN

Bestimmen eines oder mehrerer physikalischer Strompfade — S6

# Fig. 2

Fig. 3

Fig. 4

**Fig. 5A**

**Fig. 5B**

Fig. 6

Europäisches
Patentamt

European
Patent Office

Office européen
des brevets

# EUROPÄISCHER RECHERCHENBERICHT

**Nummer der Anmeldung**

EP 18 19 8916

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2017/286588 A1 (SUKHAREV VALERIY [US] ET AL) 5. Oktober 2017 (2017-10-05)<br>* Zusammenfassung *<br>* Absätze [0009], [0039], [0056] - [0069], [0076] - [0077], [0079]; Ansprüche 7, 10, 11; Abbildungen 1-6, 11; Tabelle 1 *<br>* das ganze Dokument *<br>----- | 1-13 | INV.<br>G06F17/50 |
| A | LI YANDONG ET AL: "Microscopic simulation and characteristics analysis of surface discharge based on PIC-MCC method",<br>2018 CONDITION MONITORING AND DIAGNOSIS (CMD), IEEE,<br>23. September 2018 (2018-09-23), Seiten 1-5, XP033444902,<br>DOI: 10.1109/CMD.2018.8535676<br>[gefunden am 2018-11-14]<br>* the entire document, in particular: the abstract, section II (the PIC-MCC method), section III (simulation of partial discharge) and Figure 4 *<br>----- | 1-13 | |
| A | Zoltán Donkó: "Particle in Cell simulations of capacitive RF discharges",<br>2nd Graduate Summer Institute Complex Plasmas,<br>August 2010 (2010-08), Seiten 1-52, XP055587705,<br>Gefunden im Internet:<br>URL:http://www.theo-physik.uni-kiel.de/~bonitz/si10/donko<br>[gefunden am 2019-05-13]<br>* the entire document, in particular p. 11 (Monte-Carlo particle transport), p. 17-29 (the PIC simulation method), p. 31-33 (PIC simulations of RF discharges) *<br>----- | 1-13 | RECHERCHIERTE SACHGEBIETE (IPC)<br><br>G06F<br>G01R |

Der vorliegende Recherchenbericht wurde für alle Patentansprüche erstellt

| Recherchenort | Abschlußdatum der Recherche | Prüfer |
|---|---|---|
| München | 13. Mai 2019 | Alexe, Mihai |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 18 19 8916

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-05-2019

| Im Recherchenbericht angeführtes Patentdokument | Datum der Veröffentlichung | Mitglied(er) der Patentfamilie | Datum der Veröffentlichung |
|---|---|---|---|
| US 2017286588 A1 | 05-10-2017 | KEINE | |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2953042 A1